# EUROPEAN PATENT APPLICATION

(11) **EP 4 756 806 A1**
(43) Date of publication of application: **10.06.2026**
(21) Application number: 25211587.8
(22) Date of filing: 28.10.2025
(51) Int. Cl.: G11C 7/04, G11C 16/10, G11C 16/26

(54) **STORAGE DEVICE FOR STORING DATA FOR DRIVING VEHICLE AND ELECTRONIC DEVICE INCLUDING THE SAME**

(30) Priority: 04.12.2024 KR 20240178883
(71) Applicant: Samsung Electronics Co., Ltd., Suwon-si, Gyeonggi-do 16677 (KR)
(72) Inventor: LEE, Jinwook, 16677 Suwon-si, Gyeonggi-do (KR); LEE, Heewon, 16677 Suwon-si, Gyeonggi-do (KR); SHIN, Seohyun, 16677 Suwon-si, Gyeonggi-do (KR)
(74) Representative: Kuhnen & Wacker Patent- und Rechtsanwaltsbüro PartG mbB

(57) **Abstract**

A storage device (220) is provided. The storage device (220) includes: a memory device (224) including a memory cell array, the memory cell array including a plurality of memory cells; and a memory controller (221) configured to, in response to a read command from a host device (210) indicating first data and including a tag indicating target data is to be temperature managed, obtain a read offset from a read offset table (223) based on first temperature information corresponding to the first data, change an initial read voltage to a read voltage based on the read offset, and control the first data to be read from the memory device (224) using the read voltage.

## Description

### BACKGROUND

The present disclosure relates to a storage device, and more particularly, to a storage device providing a necessary memory space to store data for driving a vehicle and an electronic device including the same.

Driving assistance technology may be used to assist a driver operating a vehicle, and autonomous driving technology may recognize a surrounding environment and determine a driving situation to control a vehicle to drive to a given destination without the driver's intervention. Vehicles that support driving assistance or autonomous driving functions may prevent collisions with obstacles in a driving path through a plurality of mounted control units and may drive to their destination on their own while adjusting speed and driving direction according to the shape of a road. For example, a control unit may be a device that integrates and controls vehicle functions using a plurality of sensors and a plurality of actuators of an autonomous vehicle. The control unit may be implemented as one of an electronic control unit (ECU), a vehicle control unit (VCU), and a zonal control unit (ZCU).

A plurality of control units perform data processing operations to control various components for driving the vehicle, may initiate memory operations including storing data generated from the corresponding operations and reading the stored data. A storage device including non-volatile memories is used to store the data. However, depending on various factors such as the vehicle's driving area, driving path, and driving environment, the temperature of the operating environment in which the storage device performs the memory operations may vary greatly. For example, a difference between a temperature when the storage device writes data and a temperature when the storage device reads the same data may be large. In this case, changes in threshold voltage distributions due to temperature changes, change in retention characteristics of memory cells, and read disturbance may occur, which may inhibit the memory operations.

Accordingly, technology is required to enable storage devices mounted in vehicles to perform memory operations with high integrity in temperature environments with large variations.

### SUMMARY

One or more example embodiments provide a storage device performing a highly reliable memory operation even in a temperature environment with large fluctuations in temperature and an electronic device including the same.

According to an aspect of an example embodiment, a storage device includes: a memory device including a memory cell array, the memory cell array including a plurality of memory cells; and a memory controller configured to, in response to a read command from a host device indicating first data and including a tag indicating target data is to be temperature managed, obtain a read offset from a read offset table based on first temperature information corresponding to the first data, change an initial read voltage to a read voltage based on the read offset, and control the first data to be read from the memory device using the read voltage.

According to another aspect of an example embodiment, an electronic device includes: a host device configured to process data for controlling vehicle driving; system memory allocated to the host device and configured to load a read offset table; and a storage device configured to perform a memory operation based on a command received from the host device. The host device is further configured to obtain a read offset from the read offset table based on first temperature information corresponding to first data to be temperature managed, and transmit a read command, the read offset, and a first address for the first data to the storage device.

According to another aspect of an example embodiment, a storage device includes: a memory device including a memory cell array, the memory cell array including a plurality of memory cells; and a memory controller configured to control the memory device to perform, in conjunction with a host device, one of a write operation and a read operation for data to be temperature managed, based on temperature information corresponding to the data.

### BRIEF DESCRIPTION OF DRAWINGS

The above and other aspects and features will be more apparent from the following description of example embodiments, taken in conjunction with the accompanying drawings, in which:
FIG. 1 is a diagram schematically illustrating a vehicle driving system according to an example embodiment;
FIG. 2A is a block diagram illustrating a vehicle control system according to an example embodiment;
FIG. 2B is a diagram specifically illustrating a write management table according to an example embodiment;
FIG. 2C is a diagram specifically illustrating a read offset table according to an example embodiment;
FIG. 3A is a flowchart for describing a method of writing target data of a host device and a storage device according to an example embodiment;
FIG. 3B is a diagram for describing a tag of a write command according to an example embodiment;
FIG. 3C is a diagram for describing a tag according to an example embodiment;
FIG. 4 is a flowchart for describing a method of accessing and managing a write management table based on a tag and an address according to an example embodiment;
FIG. 5 is a flowchart for describing a method of reading target data of a host device and a storage device, according to an example embodiment;
FIG. 6 is a flowchart for describing a method of reading target data of a storage device, according to an example embodiment;
FIG. 7 is a flowchart for describing a method of updating a read offset table, according to an example embodiment;
FIG. 8 is a diagram for describing a read offset table according to an example embodiment;
FIG. 9 is a flowchart for describing a method of updating a read offset table, according to an example embodiment;
FIGS. 10A and 10B are flowcharts for describing a method of updating a read offset table, according to an example embodiment;
FIG. 11 is a diagram for describing a read offset table according to an example embodiment;
FIG. 12 is a block diagram illustrating a vehicle control system according to an example embodiment;
FIG. 13 is a flowchart for describing a write operation method of a storage device according to an example embodiment;
FIG. 14 is a flowchart for describing a read operation method of a storage device according to an example embodiment;
FIG. 15 is a flowchart for describing a method of updating a read offset table, according to an example embodiment;
FIG. 16 is a diagram for describing a read offset table that has been updated according to an example embodiment;
FIG. 17 is a flowchart for describing a method of updating a read offset table, according to an example embodiment;
FIG. 18A is a block diagram for describing a host device according to an example embodiment;
FIG. 18B is a block diagram for describing a storage device according to an example embodiment;
FIG. 19 is a block diagram illustrating a vehicle control system according to an example embodiment;
FIG. 20 is a flowchart for describing a method of writing target data of a host device and a storage device according to an example embodiment;
FIG. 21 is a flowchart for describing a method of reading target data of a host device and a storage device, according to an example embodiment;
FIG. 22 is a block diagram for describing a host device according to an example embodiment; and
FIG. 23 is a diagram schematically illustrating an autonomous vehicle according to an example embodiment.

### DETAILED DESCRIPTION

Hereinafter, embodiments are described in detail with reference to the accompanying drawings. Each example embodiment provided in the following description is not excluded from being associated with one or more features of another example or another example embodiment also provided herein or not provided herein but consistent with the present disclosure.

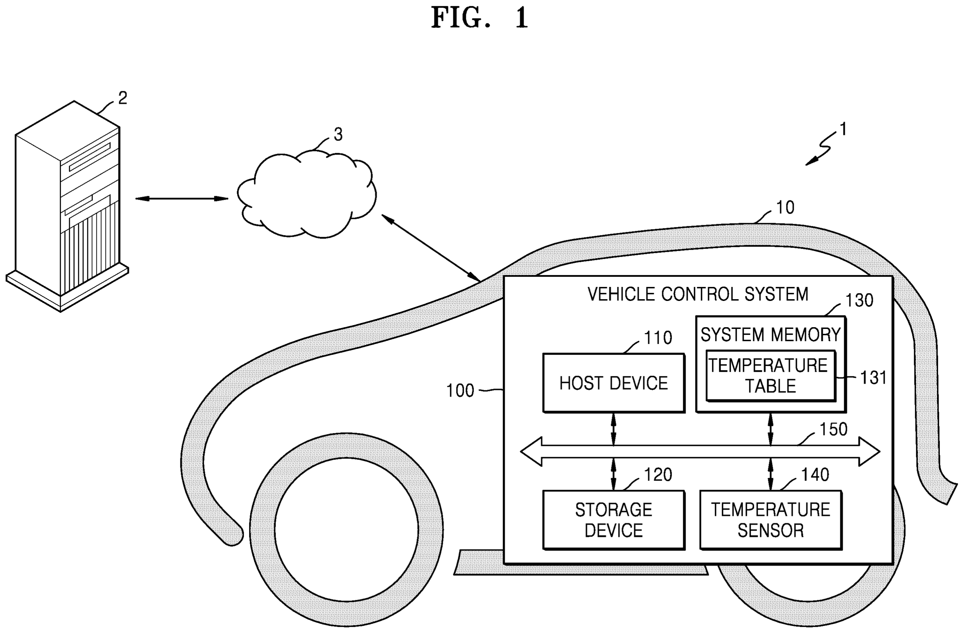

FIG. 1 is a diagram schematically illustrating a vehicle driving system 1 according to an example embodiment.

Referring to FIG. 1, the vehicle driving system 1 may include a server 2, a network 3, and a vehicle 10. The server 2 may distribute at least one of an operating system, an application, and software for driving assistance or autonomous driving, and data for their update to the vehicle 10 through the network 3. The network 3 may be implemented as one of vehicle communication technology, wireless Internet technology, short-range communication technology, and mobile communication technology. For example, at least one of wireless local area network (WLAN), wireless broadband (WiBro), and world interoperability for microwave access (WiMAX) may be used as the wireless Internet technology. For example, at least one of Bluetooth, near field communication (NFC), radio frequency identification (RFID), Infrared Data Association (IrDA), ultra wideband (UWB), and Zigbee may be used as the short-range communication technology. For example, at least one of new radio (NR), long term evolution (LTE), LTE-advanced, code division multiple access (CDMA), and global system for mobile communication (GSM) may be used as the mobile communication technology.

In an example embodiment, the vehicle 10 may include a vehicle control system 100 configured to support driving assistance or autonomous driving. The vehicle control system 100 may include a host device 110, a storage device 120, system memory 130, a temperature sensor 140, and a bus interface 150. The host device 110 may be implemented as one of an electronic control unit (ECU), a vehicle control unit (VCU), and a zonal control unit (ZCU). Furthermore, the vehicle control system 100 may be referred to as an electronic device for vehicle control.

In an example embodiment, the host device 110, the storage device 120, the system memory 130, and the temperature sensor 140 may communicate with one another through the bus interface 150. In an example embodiment to be described below, the storage device 120 may access the system memory 130 through the bus interface 150 to refer to a temperature table 131.

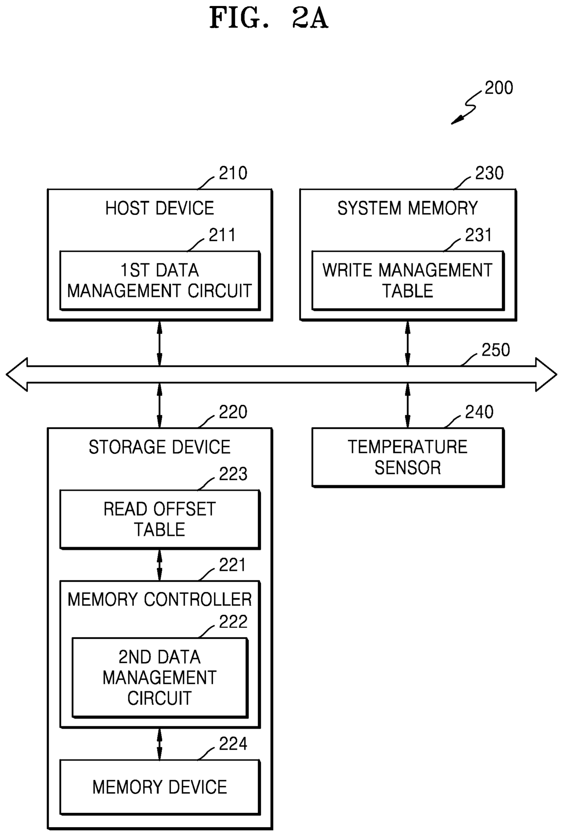

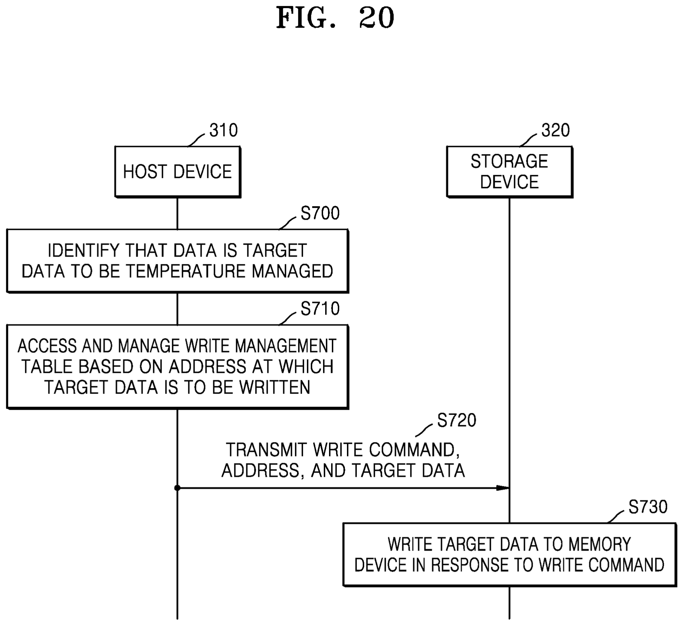

In an example embodiment, the storage device 120 and the host device 110 may operate in conjunction with each other to enable a highly reliable memory operation even in an environment in which an external temperature varies greatly according to the driving of the vehicle 10. For example, when performing a memory operation, the storage device 120 may perform the memory operation based on temperature information of target data by using resources used for a data processing operation of the host device 110. Resources of the host device 110 may include the system memory 130. The storage device 120 may access the system memory 130 allocated to the host device 110 to refer to or manage the temperature table 131 to be described below. For example, the storage device 120 may perform the memory operation by using minimal resources of the host device 110. Corresponding example embodiments are described below with reference to FIGS. 2A to 19. As another example, the storage device 120 may perform the memory operation by actively using the resources of the host device 110. Corresponding example embodiments are described below with reference to FIGS. 20 to 22.

In an example embodiment, the temperature table 131 includes information referenced and managed for the memory operation on target data. In an example embodiment, the temperature table 131 may include a write management table and a read offset table. For example, the temperature table 131 may be backed up to the storage device 120 when the vehicle control system 100 is powered off, and the temperature table 131 backed up to the storage device 120 may be loaded into the system memory 130 when the vehicle control system 100 is powered on. In some example embodiments, part of the temperature table 131 may be maintained in the storage device 120 instead of the system memory 130.

In an example embodiment, the temperature sensor 140 may directly sense the temperature of the storage device 120. In some example embodiments, the temperature sensor 140 may indirectly sense the temperature of the storage device 120 by sensing characteristics which affect the temperature of the storage device 120, such as the internal temperature of the vehicle 10 or the internal temperature of the vehicle control system 100. The temperature sensor 140 may directly or indirectly provide the sensed temperature to the host device 110 or the storage device 120 at the request of the host device 110 or the storage device 120.

In an example embodiment, the storage device 120 may perform the memory operation in conjunction with the host device 110 based on the temperature information of the target data obtained from the temperature table 131 of the system memory 130 and the temperature sensor 140. When performing a read operation on the target data, the storage device 120 may perform an optimal read operation by considering a temperature environment during the read operation and a temperature environment during a past write operation on the target data. Accordingly, the reliability of the memory operation of the storage device 120 may be greatly improved, and as a result, the driving assistance or autonomous driving performance of the vehicle control system 100 may also be improved.

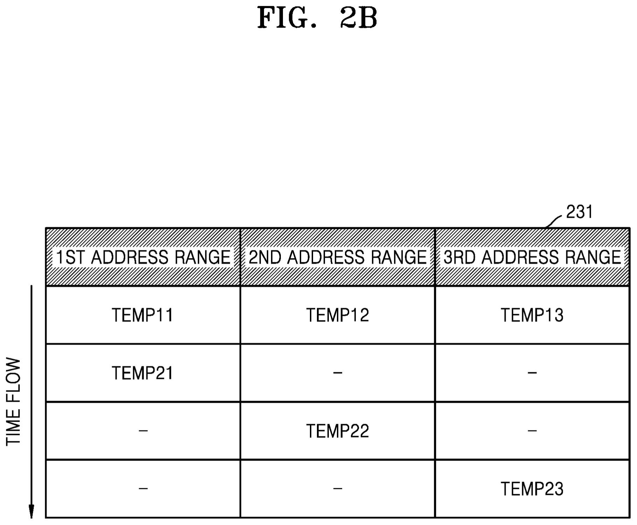

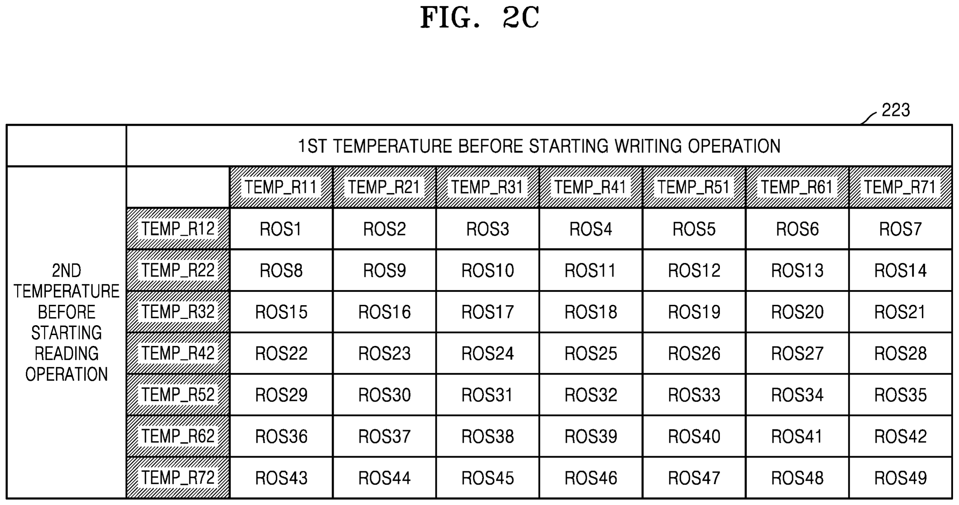

FIG. 2A is a block diagram illustrating a vehicle control system 200 according to an example embodiment (e.g., the vehicle control system 200 may be an embodiment of the vehicle control system 100 shown in Fig. 1), FIG. 2B is a diagram specifically illustrating a write management table 231 of FIG. 2A, and FIG. 2C is a diagram specifically illustrating a read offset table 223 of FIG. 2A. In FIG. 2A, an example embodiment in which the storage device 220 performs a memory operation by using relatively few resources of the host device 210 is described. In addition, hereinafter, for convenience of description, description previously given with reference to FIG. 1 is omitted.

Referring to FIG. 2A, the vehicle control system 200 may include a host device 210, a storage device 220, system memory 230, a temperature sensor 240, and a bus interface 250.

In an example embodiment, the host device 210 may include a first data management circuit 211. For example, the first data management circuit 211 may include a component for performing an operation necessary to command the memory operation on target data of the storage device 220. The first data management circuit 211 may be hardware which executes or stores instructions. The operation of the first data management circuit 211 may be understood as the operation of the host device 210 and/or the processor of the host device 210.

In an example embodiment, the storage device 220 may include a memory controller 221 and a memory device 224. In addition, the storage device 220 may store the read offset table 223. For example, the read offset table 223 may be stored in buffer memory of the memory controller 221. In some example embodiments, the read offset table 223 may be stored in the memory device 224. For example, the memory device 224 may include a non-volatile memory, such as NAND flash memory, vertical NAND (VNAND) flash memory, NOR flash memory, resistive random access memory (RRAM), phase-change random access memory (PRAM), magnetoresistive random access memory (MRAM), ferroelectric random access memory (FRAM), or spin transfer torque random access memory (STT-RAM). The memory controller 221 may include a second data management circuit 222. For example, the second data management circuit 222 may include a component for performing the memory operation on the target data based on temperature information. The second data management circuit 222 may be hardware which executes or stores instructions. The operation of the second data management circuit 222 may be understood as the operation of the storage device 220 and/or the memory controller 221.

In an example embodiment, the write management table 231 may be loaded from the storage device 220 into the system memory 230. The write management table 231 and the read offset table 223 may be included in the temperature table 131 of FIG. 1. The write management table 231 may include information referenced and managed for a write operation or a read operation on the target data of the storage device 220, and the read offset table 223 may include information referenced and managed for a read operation on the target data of the storage device 220.

In an example embodiment, the first data management circuit 211 may identify whether data is the target data on which the memory operation based on the temperature information is to be performed or general data on which a general memory operation is to be performed. The target data may be defined as data on which temperature management is to be performed. For example, the target data and the general data may be classified based on the type of memory cell to which corresponding data is written among a plurality of memory cells of a memory cell array of the memory device 224. As a specific example, data designated to be written to first memory cells operated as one of a multiple level cell (MLC), a triple level cell (TLC), and a quadruture level cell (QLC) among the plurality of memory cells of the memory device 224 may correspond to the target data. Data designated to be written to second memory cells operated as a single level cell (SLC) among the plurality of memory cells of the memory device 224 may correspond to the general data.

In addition, for example, the target data and the general data may be classified based on data types. As a specific example, the target data may correspond to data on at least one of an operating system, an application, and software executed by the host device 210 to control vehicle driving. The general data may correspond to driving data generated while a vehicle is driving. The driving data may be used for driving assistance or autonomous driving. At this time, general data that is driving data may be frequently stored or deleted because the general data corresponds to a driving record. Accordingly, the general data may be designated to be written to memory cells of the storage device 120/220 operating as a memory cell type (for example, an SLC) supporting a high program/erase (PE) cycle and target data may be designated to be written to memory cells of the storage device 120/220 operating as a memory cell type (for example, a TLC) with relatively low reliability. As described above, the plurality of corresponding memory cells (or a plurality of memory devices included in the storage device 120/220) may be classified into a space for storing the target data and a space for storing the driving data, and the type of data fitting the classified space may be appropriately stored through a namespace operation method.

In an example embodiment, based on a file header of data received from the outside, which corresponds to the data, the first data management circuit 211 may identify whether the corresponding data is the target data or the general data. For example, based on the indication that the file header of the received data is data on software executed by the host device 210, the first data management circuit 211 may identify that the corresponding data is the target data. In addition, the first data management circuit 211 may transmit the corresponding data to the storage device 220 so that the corresponding data generated by processing the data received from the outside by the host device 210 is written to the memory device 224.

In an example embodiment, the first data management circuit 211 may manage the target data to be written to a specific memory region of the memory device 224. For example, the first data management circuit 211 may manage the target data to be written to the second memory cells operated as the TLC among the plurality of memory cells of the memory device 224. The first data management circuit 211 may set a plurality of address ranges and may generate an address so that the target data is stored in one of the plurality of address ranges according to the type of the target data. For example, the plurality of address ranges may be set in units of logical block addresses (LBA). As a specific example, the first data management circuit 211 may set first to mth (m is an integer of 2 or more) address ranges, and when the target data is data on an operating system executed by the host device 210, the first data management circuit 211 may generate an address belonging to the first address range corresponding to the data of the corresponding type and may transmit the target data and the generated address to the storage device 220 along with a write command. For example, the plurality of address ranges managed by the first data management circuit 211 may be based on logical addresses, and the memory controller 221 may convert an address received from the first data management circuit 211 based on a mapping table representing a mapping relationship between logical addresses and physical addresses.

Hereinafter, an example embodiment of a write operation of the storage device 220 in conjunction with the host device 210 will be described.

In an example embodiment, the first data management circuit 211 may transmit, to the storage device 220, the write command including the tag indicating that the data currently transmitted to the storage device 220 is the target data (i.e., is to be temperature managed), the address, and the target data in order to write the target data to the memory device 224.

In an example embodiment, the second data management circuit 222 may identify that the received data is the target data based on the tag included in the write command. The second data management circuit 222 may obtain necessary temperature information from the write management table 231 and the temperature sensor 240 of the system memory 230 based on the identification result (i.e., may obtain the necessary temperature information based on identifying that the received data is the target data). The second data management circuit 222 may access the system memory 230 and may obtain, from the write management table 231, a first temperature of the storage device 220 before starting the last (or previous) write operation for the memory region of the memory device 224 corresponding to the address range to which the address of the target data belongs.

Referring further to FIG. 2B, the write management table 231 may include a temperature history when writing the target data to a memory region corresponding to each address range for first to third address ranges. For example, the first address range that is a logical address range set to store first type target data (for example, data on the operating system executed by the host device 210) and temperatures TEMP11 and TEMP21 before the write operation is initiated may be recorded in the first memory region of the memory device 224 corresponding to the first address range over time. The second address range that is a logical address range set to store second type target data (for example, data on the application executed by the host device 210) and temperatures TEMP12 and TEMP22 before the write operation is initiated may be recorded in the second memory region of the memory device 224 corresponding to the second address range over time. The third address range that is a logical address range set to store third type target data (for example, data on the software executed by the host device 210) and temperatures TEMP13 and TEMP23 before the write operation is initiated may be recorded in the third memory region of the memory device 224 corresponding to the third address range over time. For example, a difference between temperatures corresponding to one address range in the write management table 231 may exceed a threshold. That is, when a difference between a past temperature (for example, the temperature 'TEMP11') and a current temperature (for example, the temperature 'TEMP21') corresponding to one address range (for example, the first address range) exceeds the threshold, the current temperature (for example, the temperature 'TEMP21') may be recorded in the write management table 231. As a specific example, when the address range to which the address received along with the target data belongs is the first address range, the second data management circuit 222 may obtain the temperature 'TEMP21' that is the first temperature of the storage device 220 before starting the last (or previous) write operation for the first memory region of the memory device 224 corresponding to the first address range. However, the write management table 231 of FIG. 2B is provided as an example, and example embodiments are not limited thereto.

Referring back to FIG. 2A, in an example embodiment, the second data management circuit 222 may obtain the current temperature of the storage device 220 before starting the write operation for the target data from the temperature sensor 240. The current temperature may be based on a point in time at which the storage device 220 receives the write command. The second data management circuit 222 may compare the first temperature obtained from the write management table 231 with the temperature obtained from the temperature sensor 240 and may manage the write management table 231 based on the comparison result. For example, when the difference between the obtained first temperature and the obtained current temperature exceeds the threshold, the second data management circuit 222 may update the write management table 231 so that the current temperature is added to the write management table 231. The second data management circuit 222 may omit updating the write management table 231 when the difference between the obtained first temperature and the obtained current temperature is less than or equal to the threshold. Thereafter, the second data management circuit 222 may perform the write operation on the target data using the memory device 224, in response to the write command. In this way, the second data management circuit 222 may perform the write operation on the target data based on the temperature information of the target data. At this time, the write operation for the target data may include managing the write management table 231 based on the temperature information of the target data.

Hereinafter, an example embodiment of the read operation of the storage device 220 in conjunction with the host device 210 will be described.

In an example embodiment, the first data management circuit 211 may transmit, to the storage device 220, the read command including the tag indicating that the currently read requested data is the target data (i.e., is to be temperature managed) and the address, in order to read the target data from the storage device 220.

In an example embodiment, the second data management circuit 222 may identify that the data requested to be read is the target data based on the tag included in the read command. The second data management circuit 222 may obtain necessary temperature information from the write management table 231, the temperature sensor 240, and the read offset table 223 of the system memory 230 based on the identification result. The second data management circuit 222 may access the system memory 230 and may obtain, from the write management table 231, a recent first temperature corresponding to the memory region of the memory device 224 corresponding to the address range to which the address of the target data belongs. As a specific example, in the write management table 231 of FIG. 2B, the temperature 'TEMP21' that is the recent first temperature corresponding to the first memory region of the memory device 224 corresponding to the first address range to which the address of the target data belongs may be obtained.

In an example embodiment, the second data management circuit 222 may obtain a current second temperature of the storage device 220 before starting the read operation for the target data from the temperature sensor 240. The current second temperature may be based on a point in time at which the storage device 220 receives the read command.

In an example embodiment, the second data management circuit 222 may obtain a read offset from the read offset table 223 based on the obtained first temperature and the obtained second temperature.

Referring further to FIG. 2C, the read offset table 223 may include a plurality of read offsets ROS1 to ROS49 mapped to a plurality of first temperature ranges TEMP_R11 to TEMP_R71 to which the first temperature of the storage device 220 before starting the write operation for the target data may belong and to a plurality of second temperature ranges TEMP_R12 to TEMP_R72 to which the second temperature of the storage device 220 before starting the read operation for the target data may belong. Each of the plurality of read offsets ROS1 to ROS49 may be set based on the first temperature range mapped thereto among the plurality of first temperature ranges TEMP_R11 to TEMP_R71, the second temperature range mapped thereto among the plurality of second temperature ranges TEMP_R12 to TEMP_R72, and a difference between the mapped first temperature range and the mapped second temperature range. In addition, the plurality of first temperature ranges TEMP _R11 to TEMP_R71 and the plurality of second temperature ranges TEMP_R12 to TEMP_R71 may be determined based on a temperature range that the storage device 220 must support for consistency with a predetermined memory standard. As a specific example, the second data management circuit 222 may obtain the read offset ROS1 from the read offset table 223 when the first temperature obtained from the write management table 231 belongs to the temperature range TEMP_R11 and the second temperature obtained from the temperature sensor 240 belongs to the temperature range TEMP_R12. However, the read offset table 223 of FIG. 2C is provided as an example, and example embodiments are not limited thereto.

Referring back to FIG. 2A, in an example embodiment, the second data management circuit 222 may change a read voltage based on the read offset obtained in response to the read command and may perform the read operation using the memory device 224 based on the changed read voltage. For example, the second data management circuit 222 may read the target data from the memory device 224 by controlling the memory device 224 so that the memory device 224 may perform the read operation with the changed read voltage. In this way, the second data management circuit 222 may perform the read operation on the target data based on the temperature information of the target data.

In an example embodiment, the read operation for the target data of the second data management circuit 222 may include an operation of managing the read offset table 223. For example, the second data management circuit 222 may manage the read offset table 223 based on the result of the read operation for the target data. For example, the second data management circuit 222 may monitor a temperature environment in which the storage device 220 operates and may manage the read offset table 223 based on the monitoring result. In addition, for example, the second data management circuit 222 may manage the read offset table 223 based on an operating state of the memory device 224.

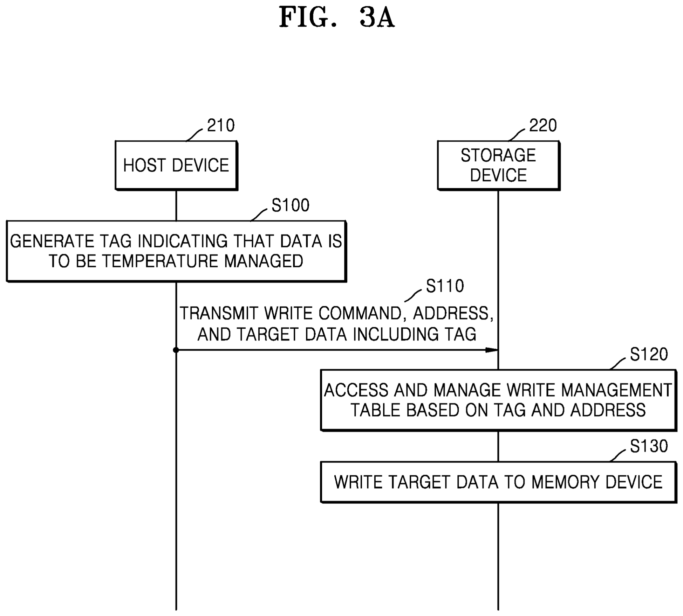

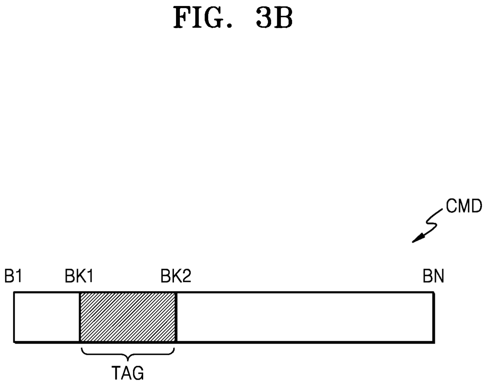

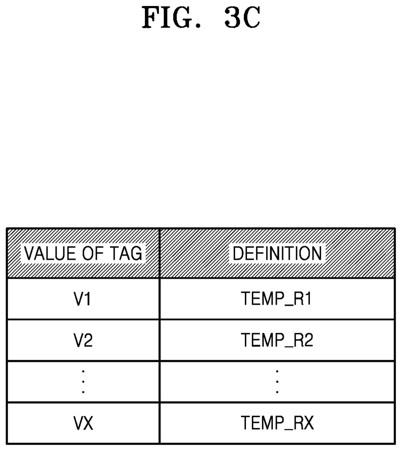

FIG. 3A is a flowchart for describing a method of writing target data of a host device 210 and a storage device 220 according to an example embodiment, FIG. 3B is a diagram for describing a tag of the write command of FIG. 3A, and FIG. 3C is a diagram for describing an example embodiment of the tag of FIG. 3B.

Referring to FIG. 3A, in operation S100, the host device 210 may generate a tag indicating that data is to be temperature managed. For example, the tag may include information allowing the storage device 220 to identify data received from the host device 210 as target data. In some example embodiments, the storage device 220 may identify the data received from the host device 210 as the target data based on an address received along with the write command from the host device 210. As described above, this may be due to a method of managing the target data designated to be written to a specific memory region corresponding to a specific address range.

In operation S110, the host device 210 may transmit the write command, the address, and the target data including the tag to the storage device 220.

Referring further to FIG. 3B, a command CMD may include first to Nth bits B1 to BN, and bits BK1 to BK2 among the first to Nth bits B1 to BN may correspond to a tag TAG. The bits BK1 to BK2 may be at positions designated through a predetermined memory standard. A configuration of the command CMD may be applied to the write command of FIG. 3A. In addition, a configuration of the command CMD may be applied to the read command to be described below. The tag TAG may indicate whether data corresponding to the command CMD is the target data or general data.

Referring further to FIG. 3C, the tag TAG may have one of a plurality of values V1 to VX, and the plurality of values V1 to VX may be mapped to a plurality of temperatures TEMP_R1 to TEMP_RX in a one-to-one manner. For example, when the tag TAG has a value of 'V1', the temperature of the storage device 220 at the time of generating the command CMD may indicate the temperature of 'TEMP_R1'. The host device 210 may determine the value of the tag TAG by accessing the temperature sensor 240 at the time of generating the command CMD and obtaining the temperature of 'TEMP_R1'.

Referring back to FIG. 3A, in operation S120, the storage device 220 may access and manage the write management table 231 based on the tag and address. For example, the storage device 220 may obtain the recent first temperature of the address range to which the address received from the write management table 231 belongs based on the tag indicating that the received data is the target data. Furthermore, the storage device 220 may obtain the current temperature from the temperature sensor 240. Additionally, when the tag of the write command indicates the current temperature, the storage device 220 may skip access to the temperature sensor 240 and may obtain the current temperature from the tag. The storage device 220 may compare the recently obtained first temperature with the obtained current temperature and may manage the write management table 231 based on the comparison result.

In operation S130, the storage device 220 may write the target data to the memory device 224.

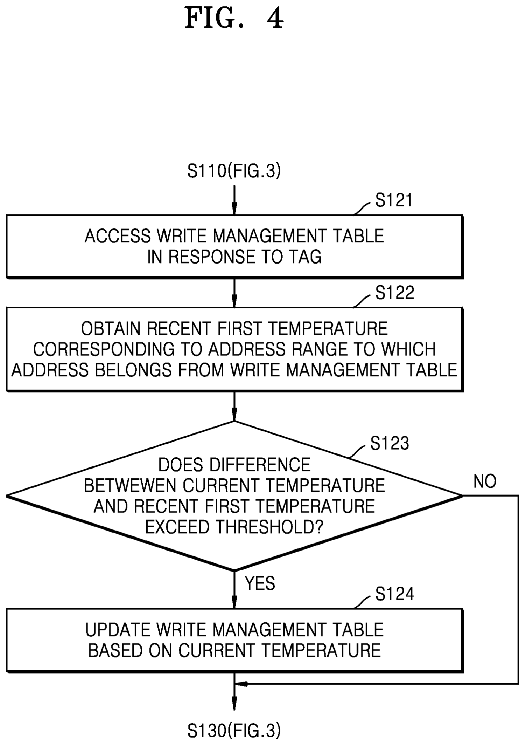

FIG. 4 is a flowchart for describing a specific example of operation S120 of FIG. 3A.

Referring to FIG. 4, in operation S121, which follows operation S110 of FIG. 3A, the storage device 220 may access the write management table 231 in response to the tag included in the write command.

In operation S122, the storage device 220 may obtain, from the write management table 231, the recent first temperature corresponding to the address range to which the address received from the host device 210 belongs. In some example embodiments, the storage device 220 may determine whether to access the write management table 231 by referring to a bitmap so that the write management table 231 may be efficiently accessed. As a specific example, the storage device 220 may manage, by using the bitmap, whether the recent first temperature corresponding to the address range to which the address received from the host device 210 belongs is stored in the write management table 231. The storage device 220 may obtain the recent first temperature by accessing the write management table 231 based on the bitmap indicating that the recent first temperature is stored in the write management table 231. In addition, the storage device 220 may directly store the current temperature in the write management table 231 based on the bitmap indicating that the recent first temperature is not stored in the write management table 231.

In operation S123, the storage device 220 may determine whether a difference between the current temperature and the recent first temperature exceeds a threshold. For example, the storage device 220 may obtain the current temperature directly from the temperature sensor 240 or from the tag included in the write command.

When operation S123 is 'YES' (i.e., the difference between the current temperature and the recent first temperature exceeds the threshold), operation S124 follows so that the storage device 220 may update the write management table 231 based on the current temperature. Referring further to FIG. 3C, for example, when the address range to which the received address belongs is the third address range, the storage device 220 may update the temperature 'TEMP13' corresponding to the recent first temperature to the temperature 'TEMP23' corresponding to the current temperature. Hereinafter, operation S130 of FIG. 3A may follow. When operation S123 is 'NO' (i.e., the difference between the current temperature and the recent first temperature does not exceed the threshold), operation S130 of FIG. 3A may follow while bypassing operation S124.

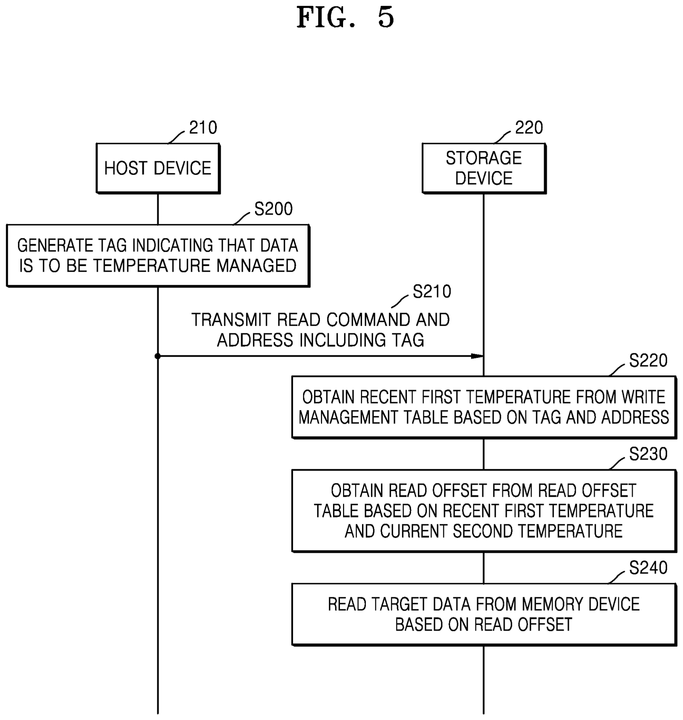

FIG. 5 is a flowchart for describing a method of reading target data of the host device 210 and the storage device 220 according to an example embodiment.

Referring to FIG. 5, in operation S200, the host device 210 may generate a tag indicating that data is to be temperature managed. For example, the tag may include information allowing the storage device 220 to identify data requested to be read from the host device 210 as target data. In some example embodiments, the storage device 220 may identify the data requested to be read from the host device 210 as the target data based on an address received along with the read command from the host device 210. As described above, this may be due to a method of managing the target data designated to be written to a specific memory region corresponding to a specific address range.

In operation S210, the host device 210 may transmit the read command including the tag and the address to the storage device 220. As illustrated in FIG. 3B described above, the tag of the read command may include bits at designated positions among the bits included in the read command.

Referring back to FIG. 5, in operation S220, the storage device 220 may obtain the recent first temperature from the write management table 231 based on the tag and address. For example, the storage device 220 may obtain the recent first temperature of the address range to which the address received from the write management table 231 belongs based on the tag indicating that the data requested to be read is the target data.

In operation S230, the storage device 220 may obtain a read offset from the read offset table based on the recent first temperature and the current second temperature. For example, the current second temperature may correspond to the temperature of the storage device 220 before starting the read operation in response to the received read command. The storage device 220 may obtain a read offset mapped to the recent first temperature and the current second temperature from the read offset table. For example, the obtained read offset may be based on a first temperature range to which the first temperature belongs, a second temperature range to which the second temperature belongs, and a difference between the first temperature range and the second temperature range.

In operation S240, the storage device 220 may read the target data from the memory device based on the read offset. For example, the storage device 220 may change a read voltage based on the read offset, and may read target data from a memory device based on the changed read voltage.

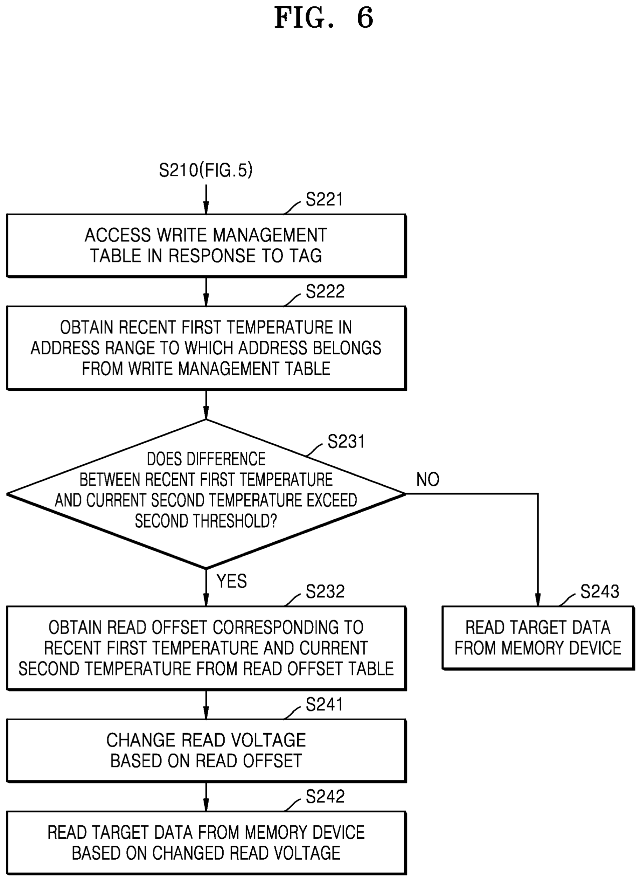

FIG. 6 is a flowchart for describing a specific example of operations S220, S230, and S240 of FIG. 5.

Referring to FIG. 6, in operation S221, which follows operation S210 of FIG. 5, the storage device 220 may access the write management table 231 in response to the tag included in the read command. In some example embodiments, the storage device 220 may access the write management table 231 by additionally referring to the bitmap described above with reference to FIG. 4.

In operation S222, the storage device 220 may obtain, from the write management table 231, the recent first temperature corresponding to the address range to which the address received from the host device 210 belongs.

In operation S231, the storage device 220 may determine whether a difference between the recent first temperature and the current second temperature exceeds a threshold. For example, the corresponding threshold may be set to a value different from the threshold value that is an update standard for the write management table 231 in FIG. 4. For example, the storage device 220 may directly obtain the current second temperature from the temperature sensor before starting the read operation in response to the received read command, or may obtain the current second temperature from the tag included in the read command.

When operation S231 is 'YES' (i.e., the difference exceeds the threshold), operation S232 follows, and the storage device 220 may obtain the read offset corresponding to the recent first temperature and the current second temperature from the read offset table.

In operation S241, the storage device 220 may change the read voltage based on the read offset. For example, the storage device 220 may change a level of the read voltage by reflecting the read offset to a preset level of the read voltage.

In operation S242, the storage device 220 may read the target data from the memory device based on the changed read voltage.

When operation S231 is 'NO' (i.e., the difference does not exceed the threshold), operation S243 follows so that the storage device 220 may read the target data from the memory device based on the read voltage having the preset level.

The target data read in operation S242 or operation S231 may be transmitted to the host device 210.

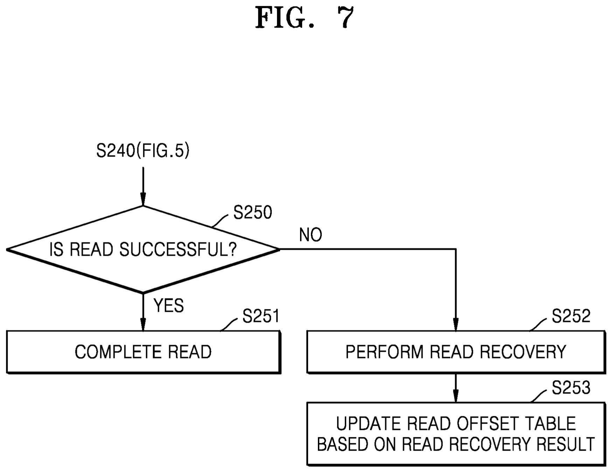

FIG. 7 is a flowchart for describing a method of updating a read offset table, according to an example embodiment.

Referring to FIG. 7, in operation S250, which follows operation S240 of FIG. 5, the storage device 220 may determine whether the read operation in operation S240 was successful. For example, the storage device 220 may decode the target data read from the memory device according to an error correction code (ECC) method and may determine whether the read operation is successful by referring to a parity bit of the decoded data.

When operation S250 is 'YES' (i.e., the read operation is determined as successful), operation S251 follows so that the storage device 220 may complete the read operation.

When operation S250 is 'NO' (i.e., the read operation is determined as not successful), operation S252 follows so that the storage device 220 may perform read recovery. For example, the storage device 220 may perform read recovery through predetermined firmware or predetermined hardware for data recovery so that the storage device 220 may determine a level of an optimal read voltage to successfully read the target data from the memory device.

In operation S253, the storage device 220 may update the read offset table based on the read recovery result. For example, the storage device 220 may update the read offset table based on the level of the optimal read voltage determined in operation S252 in response to the failure of the read operation using the read offset obtained in operation S230 of FIG. 5.

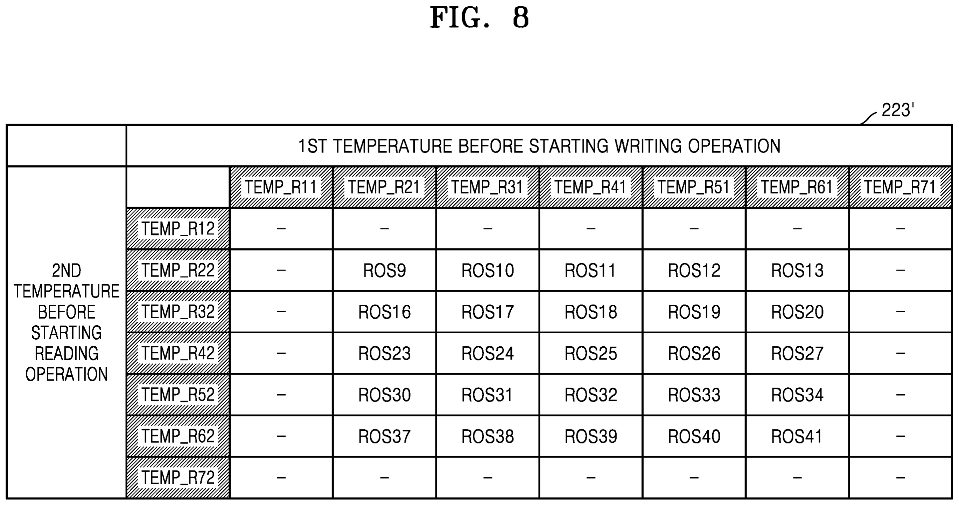

FIG. 8 is a diagram for describing a read offset table 223' according to an example embodiment.

Referring to FIG. 8, the read offset table 223' may include a plurality of first read offsets ROS9 to ROS13, ROS16 to ROS20, ROS23 to ROS27, ROS30 to ROS34, and ROS37 to ROS41 mapped to some TEMP_R21 to TEMP_R61 of the plurality of first temperature ranges TEMP_R11 to TEMP_R71 to which the first temperature of the storage device 220 before starting the write operation for the target data may belong, and some TEMP_R22 to TEMP_R62 of the plurality of second temperature ranges TEMP_R12 to TEMP_R72 to which the second temperature of the storage device before starting the read operation for the target data may belong. For example, some TEMP_R21 to TEMP_R61 of the plurality of first temperature ranges TEMP _R11 to TEMP_R71 and some TEMP_R22 to TEMP_R62 of the plurality of second temperature ranges TEMP_R12 to TEMP_R72 may be determined based on an operating environment of the storage device. That is, the read offset table 223' may be determined considering a temperature range in which the storage device is expected to operate most of the time.

In an example embodiment, in the read offset table 223', the plurality of second read offsets mapped to the remainder TEMP _R11 and TEMP_71R of the plurality of first temperature ranges TEMP_R11 to TEMP_R71 and the remainder TEMP_R12 and TEMP_72R of the plurality of second temperature ranges TEMP_R12 to TEMP_R72 may be updated and filled by the second data management circuit 222 of FIG. 2A.

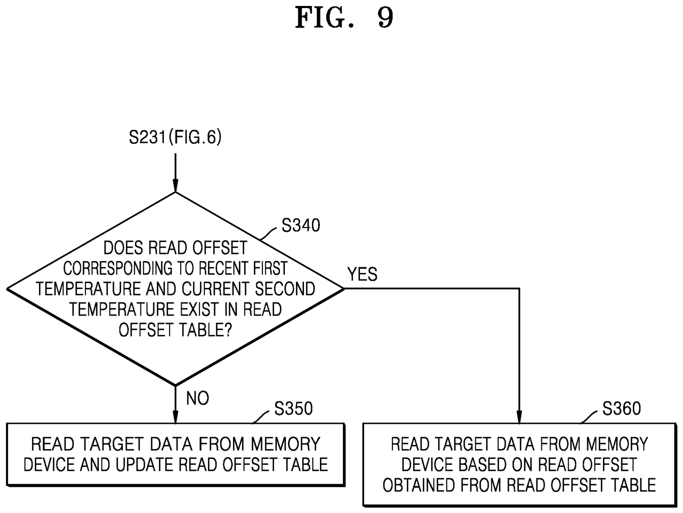

FIG. 9 is a flowchart for describing a method of updating a read offset table, according to an example embodiment.

Referring to FIG. 9, in operation S340, which follows operation S231 of FIG. 6, the storage device 220 may determine whether a read offset corresponding to the recent first temperature and the current second temperature exists in the read offset table.

When operation S340 is 'NO' (i.e., the read offset does not exist in the read offset table), operation S350 follows so that the storage device 220 may read the target data from the memory device and may update the read offset table based on the read result.

When operation S340 is 'YES'(i.e., the read offset does exist in the read offset table), operation S360 follows so that the storage device 220 may read the target data from the memory device based on the read offset obtained from the read offset table.

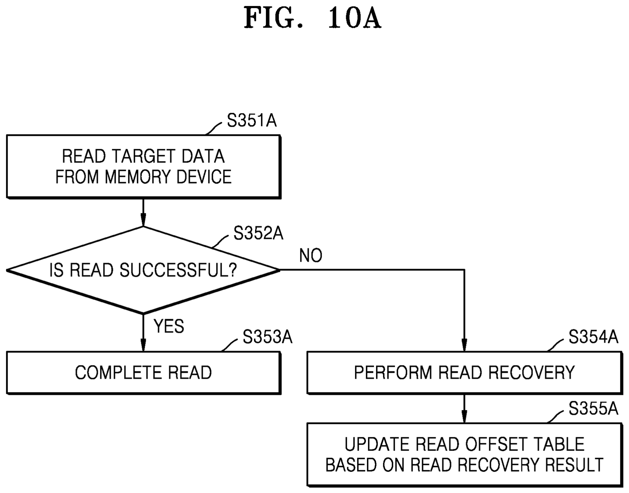

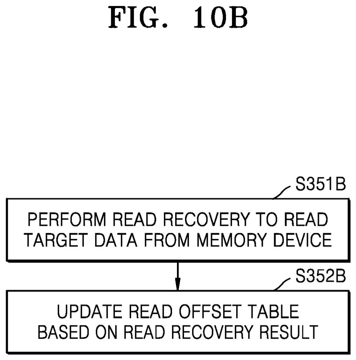

FIGS. 10A and 10B are flowcharts for describing a specific example of operation S350 of FIG. 9.

Referring to FIG. 10A, in operation S351A, the storage device 220 may read the target data from the memory device. For example, in operation S340 of FIG. 9, the storage device 220 may read the target data from the memory device based on the read voltage having the preset level in response to absence of a corresponding read offset in the read offset table 223'.

In operation S352A, the storage device 220 may determine whether the read operation in operation S351A is successful.

When operation S352A is 'YES' (i.e., the read operation is determined as successful), operation S353A follows so that the storage device 220 may complete the read operation.

When operation S352A is 'NO'(i.e., the read operation is determined as not successful), operation S354A follows so that the storage device 220 may perform read recovery. For example, the storage device 220 may sequentially execute a plurality of pieces of defense code and may perform read recovery so that the storage device 220 may determine a level of an optimal read voltage and may successfully read the target data from the memory device.

In operation S355A, the storage device 220 may update the read offset table based on the read recovery result. For example, the storage device 220 may newly fill the read offset that is absent in the read offset table based on the level of the optimal read voltage determined in operation S354A.

Referring further to FIG. 10B, in operation S351B, the storage device 220 may immediately perform read recovery in response to the absence of the read offset in operation S340 of FIG. 9 to read the target data from the memory device.

In operation S352B, the storage device 220 may update the read offset table based on the read recovery result.

In some example embodiments, the storage device 220 may generate a temporary read offset by performing an interpolation operation using read offsets in the read offset table in response to the absence of the read offset in operation S340 of FIG. 9. The storage device 220 may change the read voltage based on the temporary read offset and may perform a read operation based on the changed read voltage. In some example embodiments, the storage device 220 may update the read offset table based on a temporary read offset.

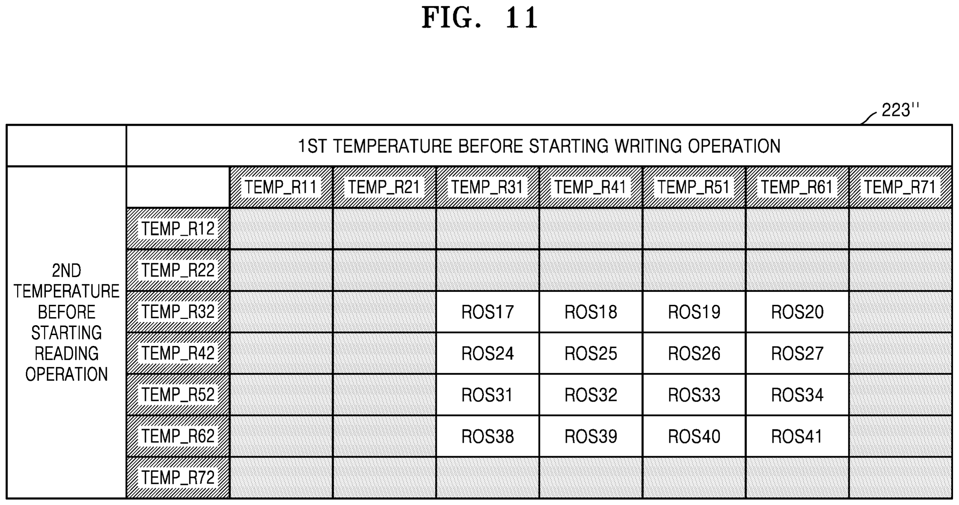

FIG. 11 is a diagram for describing a read offset table 223" according to an example embodiment.

Referring to FIG. 11, the read offset table 223" may include a plurality of first read offsets ROS17 to ROS20, ROS24 to ROS27, ROS31 to ROS34, and ROS38 to ROS41 mapped to some TEMP_R31 to TEMP_R61 of the plurality of first temperature ranges TEMP_R11 to TEMP_R71 to which the first temperature of the storage device 220 before starting the write operation for the target data may belong, and some TEMP _R32 to TEMP_R62 of the plurality of second temperature ranges TEMP_R12 to TEMP_R72 to which the second temperature of the storage device before starting the read operation for the target data may belong. For example, some TEMP_R31 to TEMP_R61 of the plurality of first temperature ranges TEMP _R11 to TEMP_R71 and some TEMP_R32 to TEMP_R62 of the plurality of second temperature ranges TEMP_R12 to TEMP_R72 may be determined based on an operating environment of the storage device. That is, the read offset table 223" may be determined considering a temperature range in which the storage device is expected to operate most of the time.

In an example embodiment, in the read offset table 223", the remainder TEMP_R11, TEMP_R21, and TEMP_R71 of the plurality of first temperature ranges TEMP_R11 to TEMP_R71 and the remainder TEMP_R12, TEMP_R22, and TEMP_R72 of the plurality of second temperature ranges TEMP_R12 to TEMP_R72 may not be covered. Accordingly, the read offset table 223" may occupy less capacity than the read offset table 223 of FIG. 2C and the read offset table 223' of FIG. 8.

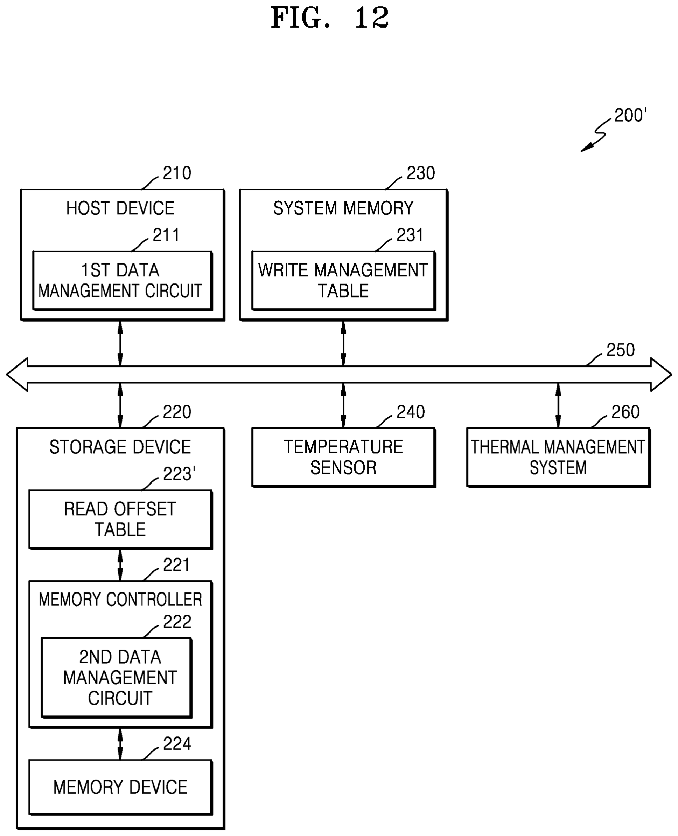

FIG. 12 is a block diagram illustrating a vehicle control system 200' according to an example embodiment. In FIG. 12, description previously given with reference to FIG. 2A is omitted.

Referring to FIG. 12, the vehicle control system 200' may include a host device 210, a storage device 220, system memory 230, a temperature sensor 240, a bus interface 250, and a thermal management system 260.

In an example embodiment, the thermal management system 260 may perform a thermal management operation to adjust the temperature of the storage device 220 under control by a first data management circuit 211. In an example embodiment, the thermal management system 260 may perform a thermal management operation to adjust an internal temperature of the vehicle control system 200' under control by the first data management circuit 211. In an example embodiment, the thermal management system 260 may include any one or any combination of a heating device, a cooling device, a fan, and a water circulator.

In an example embodiment, a second data management circuit 222 may determine whether a current first temperature of the storage device 220 before starting the write operation for the target data received from the first data management circuit 211 is covered by the read offset table 223. For example, the second data management circuit 222 may determine that the current first temperature is not covered by the read offset table 223 based on determining that the current first temperature belongs to a temperature range outside first temperature ranges (or some of the first temperature ranges) covered by the read offset table 223.

In an example embodiment, the second data management circuit 222 may transmit a thermal management request to the first data management circuit 211 in response to determining that the current first temperature is not covered by the read offset table 223. The first data management circuit 211 may control the thermal management system 260 based on the thermal management request to adjust the current first temperature so that the current first temperature may be covered by the read offset table 223. Thereafter, the second data management circuit 222 may perform the write operation on the target data.

In an example embodiment, the second data management circuit 222 may determine whether the current second temperature of the storage device 220 before starting the read operation for the target data requested to be read from the first data management circuit 211 is covered by the read offset table 223. For example, the second data management circuit 222 may determine that the current second temperature is not covered by the read offset table 223 based on determining that the current second temperature belongs to a temperature range outside second temperature ranges (or some of the second temperature ranges) covered by the read offset table 223.

In an example embodiment, the second data management circuit 222 may transmit the thermal management request to the first data management circuit 211 in response to determining that the current second temperature is not covered by the read offset table 223. The first data management circuit 211 may control the thermal management system 260 based on the thermal management request to adjust the current second temperature so that the current second temperature may be covered by the read offset table 223. Thereafter, the second data management circuit 222 may perform the read operation on the target data.

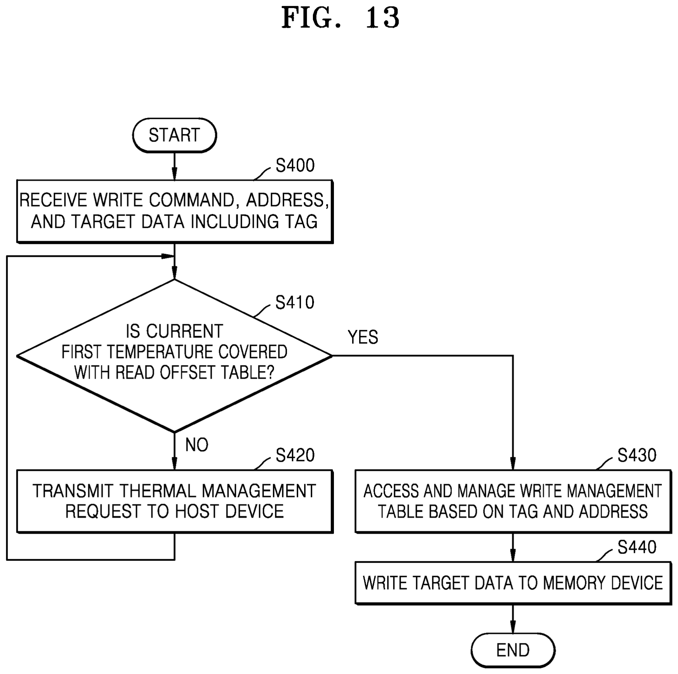

FIG. 13 is a flowchart for describing a write operation method of the storage device 220 of FIG. 12. Hereinafter, the operation of the storage device 220 may be understood as the operation of the second data management circuit 222 or the operation of the memory controller 221.

Referring to FIG. 13, in operation S400, the storage device 220 may receive the write command including the tag, the address, and the target data. The tag may indicate that currently received data is the target data.

In operation S410, the storage device 220 may determine whether the current first temperature of the storage device 220 before starting the write operation according to the received write command is covered by the read offset table 223.

When operation S410 is 'NO' (i.e., the current first temperature is not covered by the read offset table), operation S420 follows so that the storage device 220 may transmit the thermal management request to the host device 210. For example, the thermal management request may include information indicating whether to increase or decrease the current first temperature. In some example embodiments, the thermal management request may further include information indicating how much to adjust the temperature. The host device 210 may adjust the current first temperature of the storage device 220 by controlling the thermal management system 260 in response to the thermal management request. Thereafter, operation S410 may be repeated.

When operation S410 is 'YES' (i.e., the current first temperature is covered by the read offset table), operation S430 follows so that the storage device 220 may access and manage the write management table 231 based on the tag and address.

In operation S440, the storage device 220 may write the target data to the memory device 224.

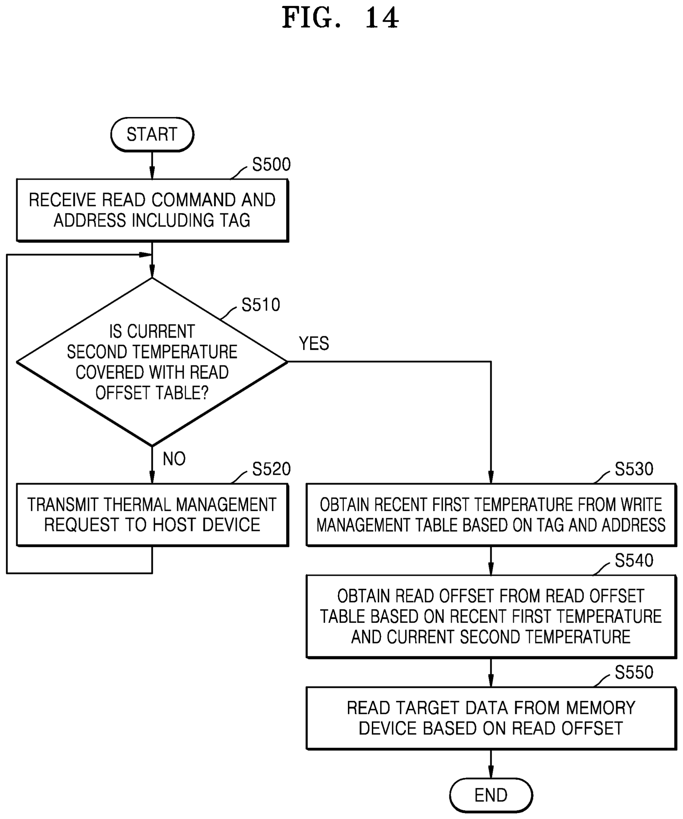

FIG. 14 is a flowchart for describing a read operation method of the storage device 220 of FIG. 12. Hereinafter, the operation of the storage device 220 may be understood as the operation of the second data management circuit 222 or the operation of the memory controller 221.

Referring to FIG. 14, in operation S500, the storage device 220 may receive the read command including the tag and the address. The tag may indicate that currently read requested data is the target data.

In operation S510, the storage device 220 may determine whether the current second temperature of the storage device 220 before starting the read operation according to the received read command is covered by the read offset table 223.

When operation S510 is 'NO' (i.e., the current second temperature is not covered by the read offset table), operation S520 follows so that the storage device 220 may transmit the thermal management request to the host device 210. For example, the thermal management request may include information indicating whether to increase or decrease the current second temperature. In some example embodiments, the thermal management request may further include information indicating how much to adjust the temperature. The host device 210 may adjust the current second temperature of the storage device 220 by controlling the thermal management system 260 in response to the thermal management request. Thereafter, operation S510 may be repeated.

When operation S510 is 'YES' (i.e., the current second temperature is covered by the read offset table), operation S530 follows so that the storage device 220 may obtain the recent first temperature from the write management table 231 based on the tag and address.

In operation S540, the storage device 220 may obtain a read offset from the read offset table based on the recent first temperature and the current second temperature.

In operation S550, the storage device 220 may read the target data from the memory device based on the read offset.

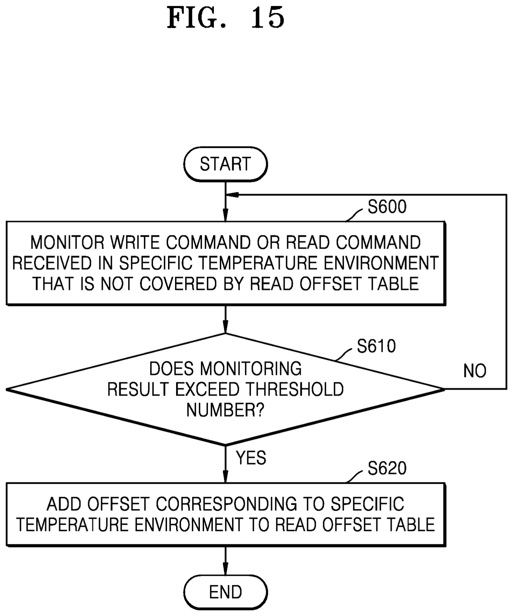

FIG. 15 is a flowchart for describing a method of updating a read offset table, according to an example embodiment.

Referring to FIG. 15, in operation S600, the storage device may monitor a write command or read command received in a specific temperature environment that is not covered by the read offset table. The specific temperature environment may correspond to a specific temperature or a specific temperature range.

In operation S610, the storage device may determine whether the monitoring result exceeds a threshold number.

When operation S610 is 'YES' (i.e., the monitoring result exceeds the threshold number), operation S620 follows so that the storage device adds a read offset corresponding to a specific temperature environment to the read offset table.

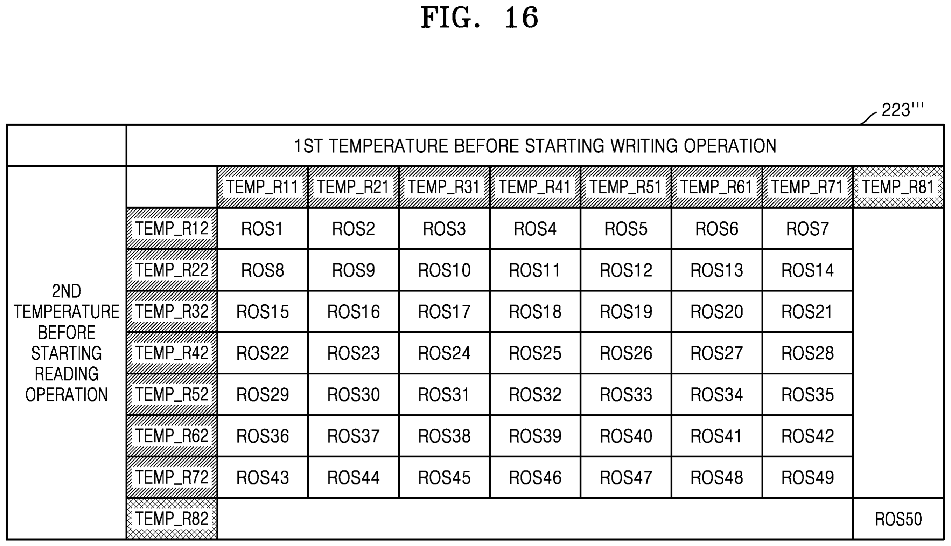

FIG. 16 is a diagram for describing a read offset table 223‴ updated by FIG. 15.

Referring to FIG. 16, the read offset table 223‴ may further include a temperature range 'TEMP_R81' and a temperature range 'TEMP_R82', and a read offset 'ROS50' mapped thereto compared to the read offset table 223 of FIG. 2C.

For example, when the write command is received to exceed the threshold number in the temperature environment corresponding to the temperature range 'TEMP_R81', and the read command is received to exceed the threshold number in the temperature environment corresponding to the temperature range 'TEMP_R82', the storage device may generate the read offset 'ROS50' corresponding to the temperature range 'TEMP_R81' and the temperature range 'TEMP_R82' to update the read offset table 223‴.

Aspects of FIGS. 15 and 16 may also be applied to the read offset tables 223' and 223" of FIGS. 8 and 11.

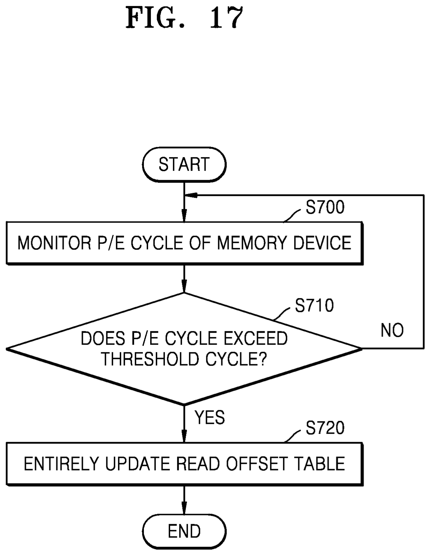

FIG. 17 is a flowchart for describing a method of updating a read offset table, according to an example embodiment.

Referring to FIG. 17, in operation S700, the storage device may monitor a P/E cycle of the memory device.

In operation S710, the storage device may determine whether the P/E cycle exceeds a threshold cycle.

When operation S710 is 'YES' (i.e., the P/E cycle exceeds the threshold cycle), operation S720 follows so that the storage device may entirely update the read offset table.

When operation S710 is 'NO' (i.e., the P/E cycle does not exceed the threshold cycle), operation S700 may be repeated.

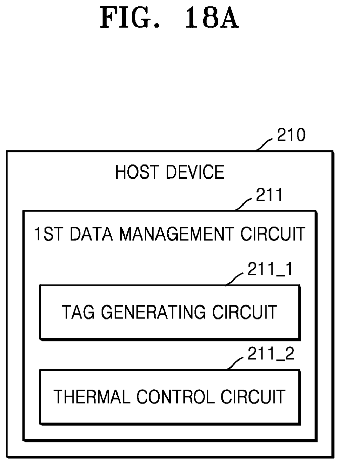

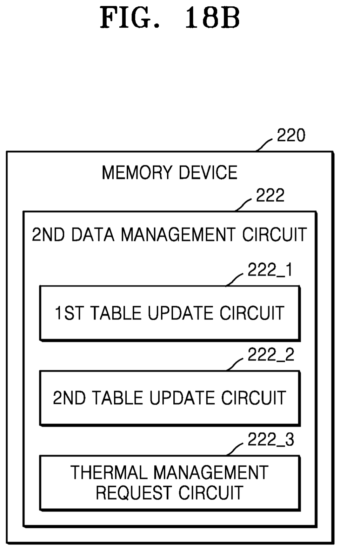

FIG. 18A is a block diagram for describing an implementation example of the host device 210 of FIG. 12, and FIG. 18B is a block diagram for describing an implementation example of the storage device 220 of FIG. 12.

Referring to FIG. 18A, the host device 210 may include the first data management circuit 211, and the first data management circuit 211 may include a tag generating circuit 211_1 and a thermal control circuit 211_2.

In an example embodiment, the tag generating circuit 211_1 may generate the tag included in the command for controlling the memory operation of the storage device 220. The tag may indicate that the data requested to be written or read is the target data.

In an example embodiment, the thermal control circuit 211_2 may control the thermal management system 260 to adjust the temperature of the storage device 220 in response to the thermal management request received from the storage device 220.

Referring further to FIG. 18B, the storage device 220 may include a second data management circuit 222, and the second data management circuit 222 may include a first table update circuit 222_1, a second table update circuit 222_2, and a thermal management request circuit 222_3.

In an example embodiment, the first table update circuit 222_1 may update the write management table 231 based on the above-described features.

In an example embodiment, the second table update circuit 222_2 may update the read offset table based on the above-described features.

In an example embodiment, the thermal management request circuit 222_3 may generate a thermal management request transmitted to the host device 210 so that the current temperature of the storage device 220 may be covered by the read offset table.

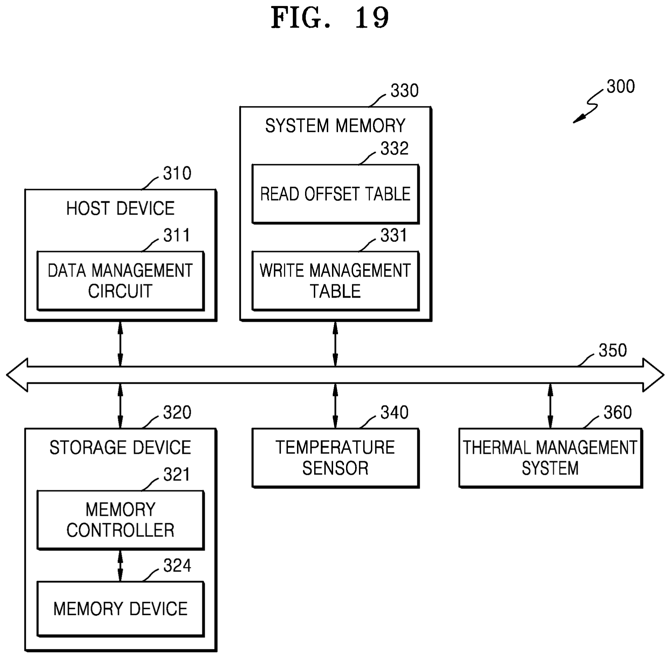

FIG. 19 is a block diagram illustrating a vehicle control system 300 according to an example embodiment. In FIG. 19, an example embodiment in which the storage device 320 performs a memory operation by actively using resources of the host device 310 is described. Hereinafter, description will focus on differences from FIG. 12.

Referring to FIG. 19, the vehicle control system 300 may include a host device 310, a storage device 320, system memory 330, a temperature sensor 340, a bus interface 350, and a thermal management system 360.

In an example embodiment, the host device 310 may include a data management circuit 311. The storage device 320 may include a memory controller 321 and a memory device 324. A write management table 331 and a read offset table 332 may be loaded into the system memory 330.

In an example embodiment, the data management circuit 311 as a component performing an operation necessary to command a memory operation for the target data of the storage device 320 may perform the operation of the first data management circuit 211 of FIG. 12 and may further perform the operation of the second data management circuit 222 of FIG. 12. A specific example is described below with reference to FIGS. 20 to 21.

FIG. 20 is a flowchart for describing a method of writing target data of the host device 310 and the storage device 320 according to an example embodiment. Hereinafter, the operation of the host device 310 may be understood as the operation of the data management circuit 311 of FIG. 19.

Referring to FIG. 20, in operation S700, the host device 310 may identify that data is the target data (i.e., is to be temperature managed).

In operation S710, the host device 310 may access and manage the write management table 331 based on the address at which the target data is to be written. For example, the host device 310 may obtain the first temperature of the storage device 320 before starting the last (or previous) write operation for the memory region of the memory device 324 corresponding to the address range to which the corresponding address belongs based on the identification result. The host device 310 may obtain a current temperature of the storage device 320 before starting the write operation for the target data from the temperature sensor 340. The current temperature may be based on a point in time at which the host device 310 generates the write command. The host device 310 may compare the first temperature obtained from the write management table 331 with the current temperature obtained from the temperature sensor 340 and may manage the write management table 331 based on the comparison result.

In operation S720, the host device 310 may transmit the write command, the address, and the target data to the storage device 320.

In operation S730, the storage device 320 may write the target data to the memory device in response to the write command.

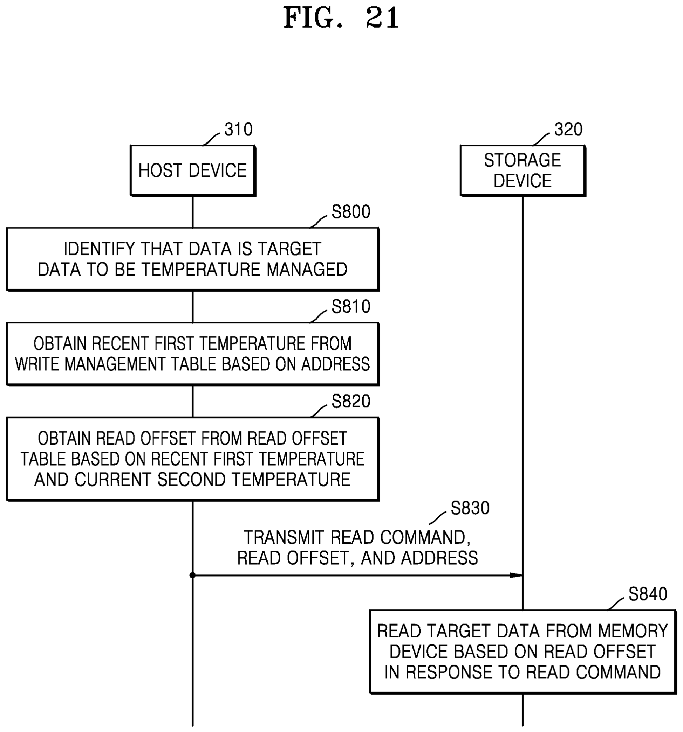

FIG. 21 is a flowchart for describing a method of reading target data of the host device 310 and the storage device 320 according to an example embodiment.

Referring to FIG. 21, in operation S800, the host device 310 may identify that data is the target data (i.e., is to be temperature managed).

In operation S810, the host device 310 may obtain the recent first temperature from the write management table 331 based on the address at which the target data is to be read. The recent first temperature may correspond to the first temperature of the storage device 320 before starting the last (or previous) write operation for a memory region of the memory device 324 corresponding to the address range to which the corresponding address belongs.

In operation S820, the host device 310 may obtain a read offset from the read offset table 332 based on the recent first temperature and the current second temperature. For example, the host device 310 may obtain a current second temperature of the storage device 320 before starting the read operation for the target data from the temperature sensor 340. The current second temperature may be based on a point in time at which the host device 310 generates the read command. The host device 310 may access the read offset table 332 to obtain the read offset mapped to the first temperature range to which the recent first temperature belongs and to the second temperature range to which the current second temperature belongs.

In operation S830, the host device 310 may transmit the read command, the read offset, and the address to the storage device 320.

In operation S840, the storage device 320 may read the target data from the memory device based on the read offset in response to the read command. For example, the storage device 320 may change a read voltage based on the read offset, and may read target data based on the changed read voltage.

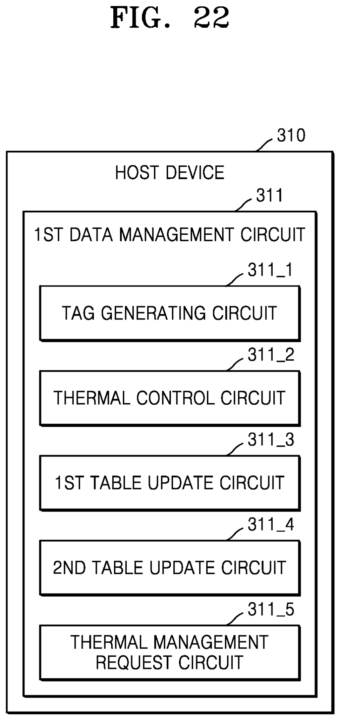

FIG. 22 is a block diagram for describing an implementation example of the host device 310 of FIG. 19.

Referring to FIG. 22, the host device 310 may include a data management circuit 311, and the data management circuit 311 may include a tag generating circuit 311_1, a thermal control circuit 311_2, a first table update circuit 311_3, and a second table update circuit 311_4.

In an example embodiment, the tag generating circuit 311_1 may generate a tag included in a command for controlling the memory operation of the storage device 320. The tag may indicate that the data requested to be written or read is the target data. In addition, the tag generating circuit 311_1 may manage the read offset to be transmitted to the storage device 320 along with the read command.

In an example embodiment, the thermal control circuit 311_2 may control the thermal management system 360 so that the current temperature of the storage device 320 may be covered by the read offset table. For example, when the memory operation of the storage device 320 is required, the thermal control circuit 311_2 may determine whether the current temperature of the storage device 320 is covered by the read offset table, and may control the thermal management system 360 so that the current temperature of the storage device 320 is adjusted when it is determined by the thermal control circuit 311_2 that the current temperature of the storage device 320 is not covered by the read offset table.

In an example embodiment, the first table update circuit 311_3 may update the write management table 331 based on the above-described features.

In an example embodiment, the second table update circuit 311_4 may update the read offset table 332 based on the above-described features. For example, the second table update circuit 311_4 may update the read offset table 332 in conjunction with the storage device 320.

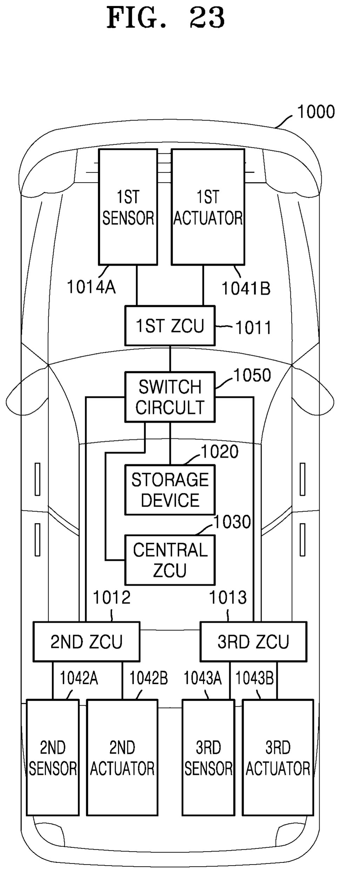

FIG. 23 is a diagram schematically illustrating an autonomous vehicle 1000 according to an example embodiment.

Referring to FIG. 23, the autonomous vehicle 1000 may include first to third ZCUs 1011, 1012, 1013, a storage device 1020, a central ZCU 1030, first to third sensors 1041A, 1042A and 1043A, first to third actuators 1041B, 1042B and 1043B, and a switch circuit 1050.

In an example embodiment, the first ZCU 1011 may be arranged at a first position of the autonomous vehicle 1000 to control the first sensor 1041A and the first actuator 1041B that are adjacent thereto. The first ZCU 1011 may be connected to the first sensor 1041A and the first actuator 1041B through a wired or wireless link. The second ZCU 1012 may be arranged at a second position of the autonomous vehicle 1000 to control the second sensor 1042A and the second actuator 1042B that are adjacent thereto. The second ZCU 1012 may be connected to the second sensor 1042A and the second actuator 1042B through a wired or wireless link. The third ZCU 1013 may be arranged at a third position of the autonomous vehicle 1000 to control the third sensor 1043A and the third actuator 1043B that are adjacent thereto. The third ZCU 1013 may be connected to the third sensor 1043A and the third actuator 1043B through a wired or wireless link. The first to third ZCUs 1011, 1012, and 1013 may support all functions in a local sub-region of the autonomous vehicle 1000. For example, the first to third ZCUs 1011, 1012, and 1013 may perform control, data processing, and data management for the first to third sensors 1041A, 1042A, and 1043A and the first to third actuators 1041B, 1042B, and 1043B that are adjacent thereto at a specific position of the autonomous vehicle 1000.

In an example embodiment, the central ZCU 1030 may be connected to the first to third ZCUs 1011, 1012, and 1013 through a wireless or wired link through the switch circuit 1050 to perform overall control and management operations on the first to third ZCUs 1011, 1012, and 1013. In some example embodiments, the central ZCU 1030 may be implemented to support functions such as an advanced driver assistance system (ADAS) or an in-vehicle infotainment (IVI).

In an example embodiment, the storage device 1020 may be connected to the first to third ZCUs 1011, 1012, and 1013 and the central ZCU 1030 through a wireless or wired link through the switch circuit 1050 to store and manage data generated by the first to third ZCUs 1011, 1012, and 1013 and the central ZCU 1030. In this way, the storage device 1020 may be implemented as an electrical & electronic (E&E) architecture in a form shared by the first to third ZCUs 1011, 1012, and 1013 and the central ZCU 1030. Based on the above-described example embodiments, the storage device 1020, the first to third ZCUs 1011, 1012, and 1013, and the central ZCU 103 may perform a memory operation based on the temperature information on the target data in conjunction with one another. Moreover, the system memory used in the above-described examples may be accessed by the storage device 1020, the first to third ZCUs 1011, 1012, and 1013, and the central ZCU 1030.

In an example embodiment, the switch circuit 1050 may include a plurality of switches, and may support smooth communication (i.e., signals may be transmitted with high integrity, and minimal signal loss and distortion) among the first to third ZCUs 1011, 1012, 1013, the central ZCU 1030, and the storage device 1020 by controlling a plurality of switches. In some example embodiments, the switch circuit 1050 may be implemented to include Ethernet switches, in which the first to third ZCUs 1011, 1012, 1013, the central ZCU 1030, and the storage device 1020 may be connected to one another through Ethernet links.

In an example embodiment, the autonomous vehicle 1000 may support vehicle communication network technology, and the first to third ZCUs 1011, 1012, and 1013, the storage device 1020, the central ZCU 1030, the first to third sensors 1041A, 1042A, and 1043A, and the first to third actuators 1041B, 1042B, and 1043B may communicate with one another based on the vehicle communication network technology. For example, the vehicle communication network technology may include at least one of a controller area network (CAN), a local interconnect network (LIN), vehicle Ethernet, FlexRay, and media oriented system transport (MOST).

For example, the first to third sensors 1041A, 1042A, and 1043A may include at least one of an inertial navigation unit (IMU) sensor, a collision sensor, a wheel sensor, a speed sensor, an inclination sensor, a weight sensor, a heading sensor, a position module, a vehicle forward/backward sensor, a battery sensor, a fuel sensor, a tire sensor, a steering sensor by steering wheel rotation, a vehicle interior temperature sensor, a vehicle interior humidity sensor, an ultrasonic sensor, an illumination sensor, an accelerator pedal position sensor, and a brake pedal position sensor.

In an example embodiment, the first to third actuators 1041B, 1042B, and 1043B may include at least one of a braking device (for example, an anti-lock braking system (ABS)), a vehicle body stability control (for example, an electronic stability control (ESC)), a steering device (for example, motor driven power steering (DPS)), an active airbag device, and a seat belt device.

However, the autonomous vehicle 1000 disclosed in FIG. 23 is only an example embodiment, and is not limited thereto, and may further include a ZCU, a sensor, or an actuator, and the arrangement of the ZCUs, sensors, and actuators may vary.

In some example embodiments, each of the components represented by a block as illustrated in FIGS. 1, 2A, 12, 18A, 18B, 19, 22 and 23 may be implemented as various numbers of hardware and/or firmware structures that execute respective functions described above, according to example embodiments. For example, at least one of these components may include various hardware components including a digital circuit, a programmable or non-programmable logic device or array, an application specific integrated circuit (ASIC), transistors, capacitors, logic gates, or other circuitry using use a direct circuit structure, such as a memory, a processor, a logic circuit, a look-up table, etc., that may execute the respective functions through controls of one or more microprocessors or other control apparatuses. Also, at least one of these components may further include or may be implemented by a processor such as a central processing unit (CPU) that performs the respective functions, a microprocessor, or the like. Functional aspects of example embodiments may be implemented in algorithms that execute on one or more processors. Furthermore, the components, elements, modules or units represented by a block or processing steps may employ any number of related art techniques for electronics configuration, signal processing and/or control, data processing and the like.

While aspects of example embodiments have been particularly shown and described, it will be understood that various changes in form and details may be made therein without departing from the scope of the following claims.

## Claims

1. A storage device (220) comprising:
a memory device (224) comprising a memory cell array, the memory cell array comprising a plurality of memory cells; and
a memory controller (221) configured to, in response to a read command from a host device (210) comprising a tag indicating first data istarget data to be temperature managed, obtain a read offset from a read offset table (223) based on first temperature information corresponding to the first data, change an initial read voltage to a read voltage based on the read offset, and read the first data from the memory device (224) using the read voltage.

2. The storage device (220) of claim 1, wherein the tag comprises bits at positions designated through a memory standard among bits included in the read command.

3. The storage device (220) of claim 1 or 2, wherein the tag further indicates a temperature range comprising a temperature of the storage device (220) before starting a read operation for the first data.

4. The storage device (220) of any one of claims 1 to 3, wherein the first temperature information comprises:
a first temperature of the storage device (220) before starting a previous write operation for a memory region corresponding to an address range comprising an address of the first data; and
a second temperature of the storage device (220) before starting a read operation for the first data.

5. The storage device (220) of claim 4, wherein the read offset is identified based on a first temperature range comprising the first temperature, a second temperature range comprising the second temperature, and a difference between the first temperature range and the second temperature range.

6. The storage device (220) of claim 4 or 5, wherein the read offset table (223) comprises a plurality of read offsets mapped to a plurality of first temperature ranges and a plurality of second temperature ranges.

7. The storage device (220) of claim 6, wherein the memory controller (221) is further configured to monitor operation of the storage device (220) while operating in a specific temperature environment that is not covered by the read offset table (223) to obtain a monitoring result, and add a new read offset corresponding to the specific temperature environment to the read offset table (223) based on the monitoring result.

8. The storage device (220) of claim 4 or 5, wherein the read offset table (223) comprises a plurality of first read offsets mapped to some of a plurality of first temperature ranges and some of a plurality of second temperature ranges.

9. The storage device (220) of claim 8, wherein some of the plurality of first temperature ranges and some of the plurality of second temperature ranges are determined based on an operation environment of the storage device (220).

10. The storage device (220) of claim 8 or 9, wherein the memory controller (221) is further configured to update the read offset table (223) by mapping a plurality of second read offsets to a remainder of the plurality of first temperature ranges and a remainder of the plurality of second temperature ranges.

11. The storage device (220) of any one of claims 8 to 10, wherein the memory controller (221) is further configured to transmit a thermal management request to the host device (210) to control the second temperature of the storage device (220) to be changed to be within the plurality of second temperature ranges.

12. The storage device (220) of any one of claims 1 to 11, wherein the plurality of memory cells comprise:
first memory cells configured to be operated as one of a multiple level cell, MLC, a triple level cell, TLC, and a quadruple level cell, QLC, to store the target data; and
second memory cells configured to be operated as single level cells, SLC, to store general data comprising driving data.

13. The storage device (220) of any one of claims 1 to 12, wherein in response to a write command comprising a tag that indicates second data is the target data, the memory controller (221) is further configured to write the second data to the memory device (224), and wherein the memory controller is further configured to manage a write management table (231) based on the tag and an address.

14. The storage device (220) of claim 13, wherein the memory controller (221) is further configured to obtain, from the write management table (231), a first temperature of the storage device (220) before starting a previous write operation for a memory region corresponding to an address range comprising the address, and manage the write management table (231) based on a comparison of a temperature of the storage device (220) before starting a write operation for the second data with the first temperature.

15. The storage device (220) of claim 13 or 14, wherein the memory controller (221) is further configured to transmit a thermal management request to the host device (210) to control a temperature of the storage device (220), and to start a write operation for the second data based on a current temperature being covered by the read offset table (223).
